Europäisches Patentamt

European Patent Office

Office européen des brevets

(11) Publication number: **0 193 156 B1**

# EUROPEAN PATENT SPECIFICATION

(45) Date of publication of patent specification: **06.05.92**  (51) Int. Cl.5: **H01B 7/08**

(21) Application number: **86102366.1**

(22) Date of filing: **24.02.86**

(54) Flexible cable and method of manufacturing thereof.

(30) Priority: **25.02.85 JP 34503/85**

(43) Date of publication of application:
**03.09.86 Bulletin 86/36**

(45) Publication of the grant of the patent:
**06.05.92 Bulletin 92/19**

(84) Designated Contracting States:
**DE FR GB**

(56) References cited:
**GB-A- 1 266 402**
**GB-A- 1 390 923**
**US-A- 3 576 723**

(73) Proprietor: **Oki Electric Industry Company, Limited**
**7-12, Toranomon 1-chome Minato-ku**
**Tokyo 105(JP)**

(72) Inventor: **Kikuchi, Hiroshi c/o Oki Electric Industry Co.,Ltd.**
**7-12, Toranomon 1-chome**
**Minato-ku Tokyo(JP)**
Inventor: **Tanuma, Jiro c/o Oki Electric Industry Co., Ltd.**
**7-12, Toranomon 1-chome**
**Minato-ku Tokyo(JP)**
Inventor: **Akutsu, Naoji c/o Oki Electric Industry Co., Ltd.**
**7-12, Toranomon 1-chome**
**Minato-ku Tokyo(JP)**

(74) Representative: **Betten, Jürgen, Dipl.-Ing. et al**
**Patentanwälte Betten & Resch Reichenbach-strasse 19**
**W-8000 München 5(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a flexible cable having excellent dielectric strength against static electricity and a method of manufacturing thereof.

In recent years, flexible printed circuit boards have come to be profitably employed in various fields as important parts for use in mounting thereon many electronic circuitries being central to computer application thereof such as circuit boards and wiring parts, etc.. Such a flexible printed circuit board when employed as a circuit board is multilayer-structured and adapted to mount electronic parts directly thereon, while it is miniaturized and made lightweight by making use of its flexible structure as well as put in order within a limited space for higher density mounting. Employed as wiring parts, the flexible printed board is adapted to wire together individual connections in wire harness as being useful for elimination or reduction of labor as well as prevention of erroneous wiring. In addition, it is also widely used for wiring various movable portions in view of flexible and lightweight structure thereof.

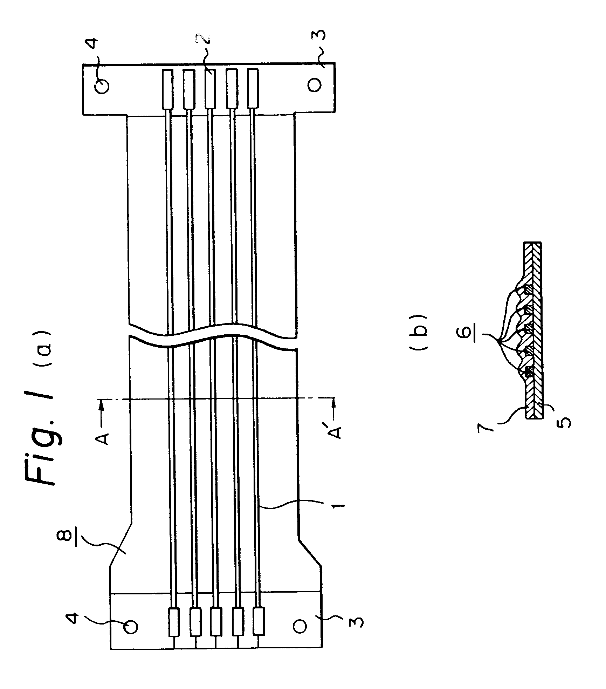

Referring to Fig. 1 illustrating a prior flexible cable structure, a flexible cable has a conducting part 1 thereof, a terminal 2 being an extension of the conducting part 1, and a lug 3 for attaching thereto a set screw having a locking hole 4. The flexible cable is mounted on a base 5 comprising a high polymer material such as polyester and polyimide. The base 5 is of a flame-retardant material with thickness of several tens of a micrometer. Designated at 6 is a copper foil pattern formed as the conducting part 1 and patterned by subjecting the copper foil bonded onto the base 5 to etching. A cover layer 7 formed by the same material as that of the base 5 is arranged to cover the copper foil pattern 6 on the base 5 therewith. Designated at 8 is an insulator part comprising the base 5 and the cover layer 7. Since the terminal part 2 is brought into contact with a pattern of any other counterpart, the base material (not shown)and the cover layer 7 are eliminated at this place. Moreover, the terminal 2 , since inferior in its contact resistance, is further subjected to processing such as gold plating. The copper foil pattern 6 is constructed to keep an interval capable of securing dielectric strength against the adjoining portion of the copper foil pattern while keeping a distance (distance between edges) away from both sides of the insulator 8. The cover layer 7 and the copper foil pattern 6, respectively have their thicknesses of about several tens of a micrometer and are sufficiently bending-resistant. Accordingly, the flexible cable is in wide use as a cord for transmitting an electric signal to a mechanically movable portion including a printer carriage cable.

However, such a prior flexible cable suffers from some drawbacks. Namely, bringing a subject having static electricity of high voltage near a flexible cable of the type described above, a high electric field is generated between the conductive part of the cable and the subject whereby a high polymer material such as polyester, etc., located therebetween is polarized. Therefore, the cover layer is subjected to dielectric breakdown to cause electric discharge to be produced among different portions of the copper foil pattern being a conductive part, and thus any electric circuit connected with the copper foil pattern is broken as the result.

GB-A 1 390 923 discloses a flexible cable having the features mentioned in the preamble of Claim 1, the copper foil pattern being enclosed by a screening layer and an insulating layer.

From GB-A-1 266 402, a method for manufacturing a flexible cable is known which comprises the steps of bonding a copper foil to a base; preparing a copper foil pattern by subjecting said bonded copper foil to etching and covering said pattern with a cover layer.

US-A 3 576 723 discloses a flexible cable comprising a copper foil pattern forming internal grounding conductors and signal lines, the grounding conductors being connected to shielding layers. The flexible cable is completely sealed by an outer insulating sealing layer.

It is an object of the present invention to provide a flexible cable capable of preventing the cover layer from being subjected to dielectric breakdown even with a subject having static electricity of high voltage brought near the flexible cable.

Another object of the present invention is to provide a flexible cable capable of preventing an electronic circuit connected with the conductive part from being broken,even if the cover layer is subjected to dielectric breakdown owing to its exposure to static electricity of high voltage to cause electric discharge in the conductive part to be produced.

Still another object of the present invention is to provide a method of manufacturing a flexible cable capable of preventing electric discharge from being produced in the conductive part due to dielectric breakdown of the cover layer caused by static electricity of high voltage.

With the flexible cable according to the present invention the exposed conductive pattern can be used as FG (flame ground) for a signal line running therealong. The pattern is directly connected to FG, i.e. grounded via connectors.

When a subject having static electricity of high voltage is brought near to the flexible cable, spark discharge is caused, before any spark discharge is produced between the subject and each of the different portions of the conducting pattern serving as signal lines, between the subject and portions of the pattern serving as a ground line, because conductive parts of the flexible cable are exposed to the outside. Accordingly, dielectric breakdown of the insulator part caused by static electricity of high voltage, and dielectric breakdown of an electric circuit of any apparatus connected with portions of the pattern serving as signal line can be prevented.

The flexible cable having a conducting part comprising a plurality of different portions of the pattern can be manufactured with ease while permitting cover layer to be laminated on a prescribed portion of the pattern so as to permit the above pattern portion to be at least partly exposed to the outside in its longitudinal direction.

Furthermore, the flexible cable can be manufactured with ease since the outer shape of the flexible cable is to be cut out together with a part of the conductive pattern whereby pattern edges located along one or both edges of the flexible cable are exposed.

The above and other objects, features and advantages of the present invention will become more apparent from the following description when taken in conjunction with the accompanying drawings in which preferred embodiments of the present invention are shown by way of illustrative example.

Figs. 1(a) and (b) are respectively a plan view and a cross sectional view along a line A-A' both illustrating a prior flexible cable,

Figs. 2(a), (b) and (c) are respectively a plan view, a cross sectional view along a line B-B', and a cross sectional view along a line C-C' all illustrating an embodiment of a flexible cable according to the present invention,

Fig. 3 is a view illustrating the effect of the present invention,

Fig. 4(a) is a flowchart illustrating an embodiment of a method of manufacturing a flexible cable according to the present invention,

Figs. 4(b), (c), (d) and (e), respectively are a cross sectional view of the flexible cable illustrating each process of the method of manufacturing thereof in Fig. 4(a),

Figs. 5(a) and (b), respectively are a cross sectional view illustrating another embodiment of a flexible cable according to the present invention, and

Fig. 6(a) is a flowchart illustrating another embodiment of a method of manufacturing a flexible cable according to the present invention, and

Figs. 6(b), (c), (d) and (e), respectively are a cross sectional view of the flexible cable illustrating each process of the method of manufacturing thereof in Fig. 6(a).

Operation of a flexible cable according to the present invention will be described with reference to the accompanying drawings wherein the same symbols shall be applied to common elements through the drawings.

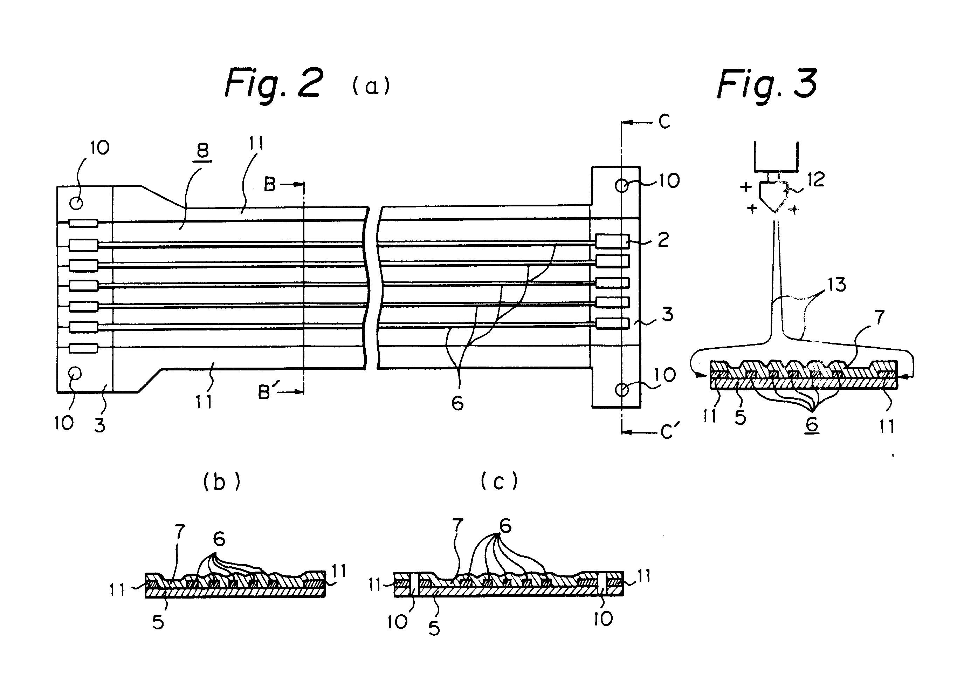

As shown in Fig. 2(a) illustrating an embodiment of a flexible cable according to the present invention, the flexible cable shown here has a copper foil pattern newly formed fully extending to both sides of the flexible cable of Fig. 1. In detail, copper foil pattern 11 exposed in its edges to the outside is newly formed on the conductive part 1 while fully extending to both sides of the flexible cable previously formed, in addition to copper foil patterns 6 used as usual signal lines, and, furthermore, is extended to the terminals 2 or to the lug holes 10. The cover layer 7 is eliminated at locking holes 10 and at the terminals 2. These portions are brought into close contact with those counterparts, e.g., a FG part pattern of a base substrate (not shown) assembled into a business machine, or they are structured to secure electric contact with the both side copper foil patterns 11 via connectors, etc..

Referring to Fig. 2(b), it is understood that besides the usual copper foil pattern 6, the copper foil patterns 11 exposed to edges of both sides of the flexible cable are adapted to run to peripheral edges of the locking holes 10 and covered with the cover layer 7 in their upper parts.

In Fig. 3 illustrating the effect of the present invention, an electric discharge route is shown as static electricity having high voltage (e.g., 10 to 20 kV) is brought near the flexible cable.

Gradually approaching a subject charged to high voltage such as a probe 12 to the flexible cable from a distant place, an electric field (electric lines of force) is concentrated among the tip of the probe 12 and the copper foil patterns 6 each used as signal lines located in the flexible cable. Thereupon, spark discharge is caused, before the cover layer 7 is subjected to dielectric breakdown owing to high dielectric strength of the flexible cable to cause spark discharge among the cover laying itself and the copper foil patterns 6, among the cover laying and the edges of the copper foil patterns 11 disposed on both sides of the flexible cable, namely, between the cover laying and the atmosphere lower in the dielectric strength than the cover layer 7. Accordingly, electric charges with which the probe 12 is charged are connected with the ground potential through the copper foil patterns 11, i.e., the FG part pattern are removed, whereby dielectric breakdown of the cover layer 7 due to static electricity can be prevented. Here, although the copper foil patterns 11 were formed on both sides of the flexible pattern in the above description, only one copper foil pattern may be formed on any of both sides without imposing any appreciable bad affection thereon.

A method of manufacturing the flexible cable so constructed will be described.

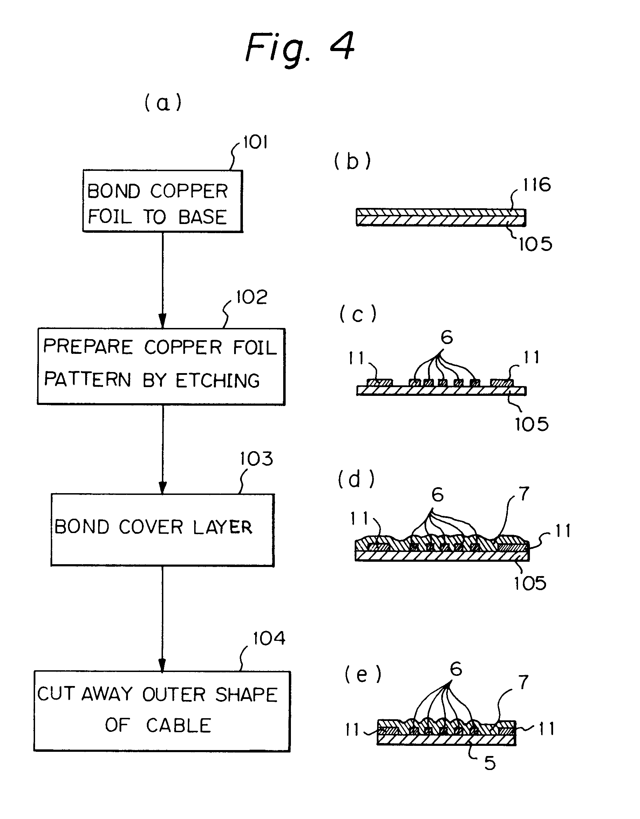

As shown in Fig. 4 providing a flowchart and cross sectional views relating to an embodiment of the method of manufacturing the flexible cable according to the present invention, a base comprising a high polymer material such as polyester, etc., and copper foils are first prepared, and in Step 101 the copper foils 116 are bonded to the base and laminated on the base 105. In Step 102, the laminated copper foils are subjected to etching to form copper foil patterns 6 and 11 on the base 105. In Step 103, the cover layer 7 is bonded to the base 105 on the side of copper foil patterns 6, 11 of the base 105 to cover the copper foil patterns 6 and 11 therewith. In Step 104, the flexible cable so formed is cut off into a prescribed shape. In the instance, the copper foil pattern 11, i.e., a pattern for grounding is cut off so as to be exposed on both sides of the flexible case.

Hereupon, the Step 104 is particularly important for the method of manufacturing the flexible cable according to the present invention wherein the copper pattern 11 is cut off while partly left behind and at least one copper foil pattern 11 may be cut off.

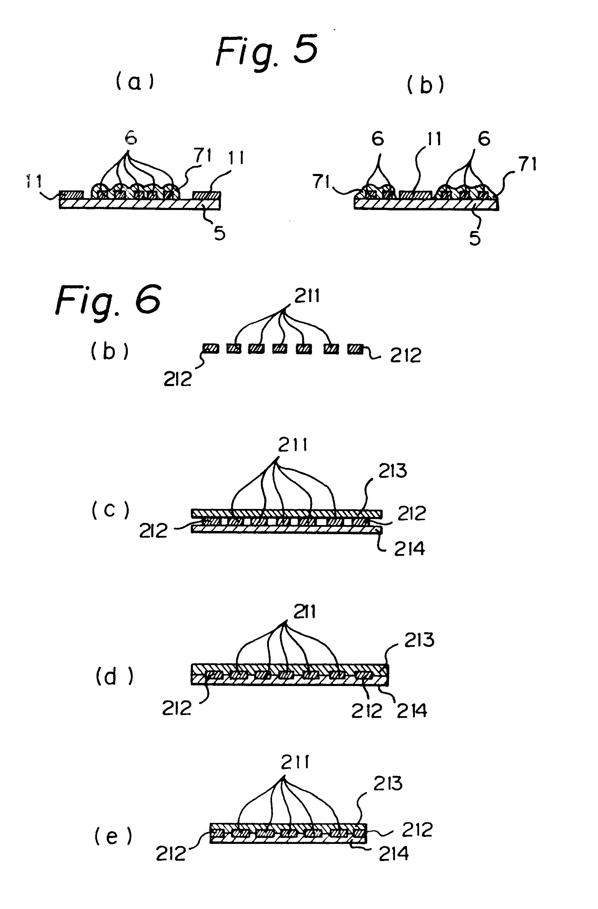

Referring to Fig. 5 illustrating, in cross section, another embodiment of the flexible cable according to the present invention, the cover layer 71 is bonded to the base 5 so as to cover only the copper foil pattern 6 while leaving the copper foil pattern 11 exposed. This processing is effected in the Step 103 in this case. Here, the copper foil pattern 11 is not necessarily needed to be cut off in Step 104. Moreover, in this case, the copper foil pattern used for a grounding conductor is provided, in Fig. 5(a), on both sides or one side of the flexible, while in Fig. 5(b) it is provide inside the flexible cable.

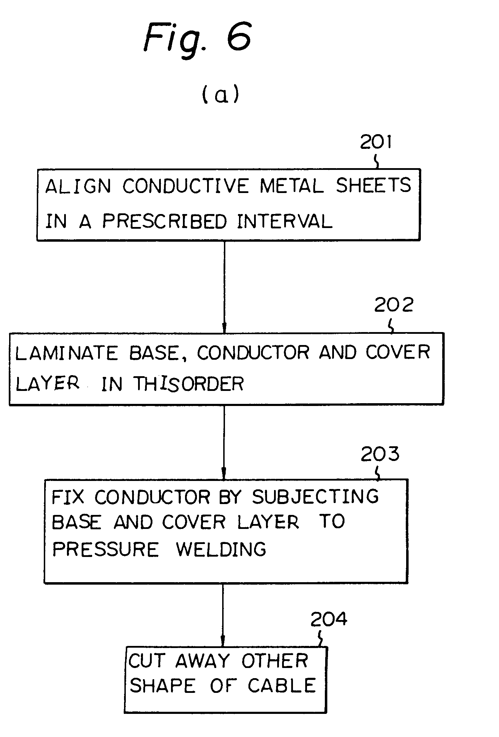

In Fig. 6 providing a flowchart and cross sections illustrating another embodiment of a method of manufacturing the flexible cable according to the present invention, a base comprising a high polymer material such as polyester, etc., and a cover layer are first prepared, and in Step 201 a plurality of thin metal sheet conductors 211, 212 being conducting parts of the cable are aligned in spaced relation in a prescribed interval by making use of a jig. In Step 202, the metal sheet conductors 211, 212 are put between a base 214 and a cover layer 213 in a sandwiching relation and laminated. In Step 203, the base 214 and the cover layer 213 are subjected to thermocompression bonding from both sides thereof to fix the metal sheet conductors 211, 212. In Step 204, the flexible cable so constructed is cut off into a prescribed shape. In the instance, the flexible cable is cut off such that the metal sheet conductor 212, i.e., the pattern for grounding is exposed on both side ends of the flexible cable. Thereupon, any one of the metal sheet conductors 212 on both sides of the flexible cable may be cut off.

Furthermore, in Step 202 or 203, the cover layer 213 may cover only the metal sheet conductor 211 while the metal sheet conductor 212 may be exposed. Thereupon, it is only normal that in Step 204 the metal sheet conductor 212 may not be cut off. This case corresponds to that of Fig. 5-(a). In addition, the metal sheet conductor 212 may be disposed inside the flexible cable. This case corresponds to that of Fig. 5(b).

## Claims

1. A flexible cable comprising: an insulating base (5; 214) supporting at least one signal conductor (6; 211) and an insulating cover layer (7; 71; 213), said base and cover layer enclosing the or each signal conductor, said cable also comprising at least one grounded conductor (11, 212) extending in the direction of the cable and being supported by the insulating base (5; 214) characterized in that the or each grounded conductor is exposed along the length of the cable directly to the exterior of said cable.

2. A flexible cable according to claim 1 being substantially flat and having two edges extending in the direction of the cable, characterized in that said grounded conductor is provided at or on one or each edge of said flexible cable.

3. A flexible cable according to claim 1 being substantially flat and having two edges extending in the direction of the cable, characterized in that said grounded conductor is disposed beween two signal conductors (6).

4. A method of manufacturing a flexible cable according to claim 1 comprising the steps of: bonding a copper foil to a base (5); preparing a copper foil pattern (6, 11) by subjecting said bonded copper foil to etching; and covering said pattern (6, 11) with a cover layer (7); characterized by the step of cutting off said base (5) and said cover layer (7) such that the or each additional conductor (11) is being exposed along the length of the cable to the exterior of said cable.

5. A method of manufacturing a flexible cable according to claim 1, comprising the steps of: bonding a copper foil to a base (5); preparing a copper foil pattern (6, 11) by subjecting said bonded copper foil to etching; and bonding a cover layer (71) to the etched copper foil; characterized by bonding only a prescribed portion (6) of said copper foil pattern (6, 11) with said cover layer (71) such that said copper foil is exposed along the length of the cable to the exterior of the cable.

6. A method of manufacturing a flexible cable according to claim 1, comprising the steps: disposing a plurality of signal (211) and ground (212) sheet conductors in a prescribed interval to each other; sandwiching said sheet conductors (211, 212) between a base (214) and a cover layer (213); bonding the cover layer (213) to the base (214) to fix the sheet conductors (211, 212); and cutting off the outer edge of the flexible cable to expose the or each grounded conductor (212) along the length of the cable to the exterior of said cable.

**Revendications**

1. Câble flexible comportant : une base isolante (5 ; 214) supportant au moins un conducteur (6 ; 211) de signaux et une couche isolante (7 ; 71 ; 213) de recouvrement, ladite base et ladite couche de recouvrement renfermant le ou chaque conducteur de signaux, ledit câble comportant aussi au moins un conducteur (11, 212) à la masse s'étendant dans la direction du câble et supporté par la base isolante (5 ; 214), caractérisé en ce que le ou chaque conducteur à la masse est exposé sur la longueur du câble directement à l'extérieur dudit câble.

2. Câble flexible selon la revendication 1, étant sensiblement plat et ayant deux bords s'étendant dans la direction du câble, caractérisé en ce que ledit conducteur à la masse est prévu à, ou sur, un ou chaque bord dudit câble flexible.

3. Câble flexible selon la revendication 1, étant sensiblement plat et ayant deux bords s'étendant dans la direction du câble, caractérisé en ce que ledit conducteur à la masse est disposé entre deux conducteurs (6) de signaux.

4. Procédé de fabrication d'un câble flexible selon la revendication 1, comprenant les étapes qui consistent : à lier une mince feuille de cuivre à une base (5) ; à préparer un dessin (6, 11) de la mince feuille de cuivre en soumettant ladite mince feuille de cuivre liée à une gravure ; et à recouvrir ledit dessin (6, 11) d'une couche (7) de recouvrement ; caractérisé par l'étape consistant à couper ladite base (5) et ladite couche (7) de recouvrement de manière que le ou chaque conducteur supplémentaire (11) soit exposé sur la longueur du câble à l'extérieur dudit câble.

5. Procédé de fabrication d'un câble flexible selon la revendication 1, comprenant les étapes qui consistent : à lier une mince feuille de cuivre à une base (5) ; à préparer un dessin (6, 11) de la mince feuille de cuivre en soumettant ladite mince feuille de cuivre liée à une gravure ; et à lier une couche (71) de revêtement à la mince feuille de cuivre gravée ; caractérisé en ce qu'il consiste à lier uniquement une partie prescrite (6) dudit dessin (6, 11) de la mince feuille de cuivre avec ladite couche (71) de recouvrement afin que ladite mince feuille de cuivre soit exposée sur la longueur du câble à l'extérieur du câble.

6. Procédé de fabrication d'un câble flexible selon la revendication 1, comprenant les étapes qui consistent : à disposer plusieurs conducteurs (211) de signaux et (212) de masse, en feuille, à un intervalle prescrit les uns par rapport aux autres ; à prendre en sandwich lesdits conducteurs (211, 212) en feuille entre une base (214) et une couche (213) de recouvrement ; à lier la couche (213) de recouvrement à la base (214) pour fixer les conducteurs (211, 212) en feuille ; et à couper le bord extérieur du câble flexible pour exposer le ou chaque conducteur (212) à la masse sur la longueur du câble à l'extérieur dudit câble.

**Patentansprüche**

1. Biegsames Kabel mit einer mindestens einen Signalleiter (6; 211) und eine Isolierdeckschicht (7; 71; 213) tragenden Isoliergrundplatte (5; 214), wobei Grundplatte und Deckschicht den oder die Signalleiter umschließen, weiterhin mit mindestens einem geerdeten Leiter (11, 212), der sich in Richtung des Kabels erstreckt und von der Isoliergrundplatte (5; 214) getragen wird, dadurch gekennzeichnet, daß der bzw. jeder der geerdeten Leiter entlang der Kabellänge direkt zur Außenseite des Kabels freiliegt.

2. Biegsames Kabel gemäß Anspruch 1, das im wesentlichen flach ist und zwei in Richtung des Kabels verlaufende Kanten aufweist, dadurch gekennzeichnet, daß der geerdete Leiter an oder auf einer bzw. jeder der Kanten des biegsamen Kabels vorgesehen ist.

3. Biegsames Kabel gemäß Anspruch 1, das im wesentlichen flach ist und zwei in Richtung des Kabels verlaufende Kanten aufweist, dadurch gekennzeichnet, daß der geerdete Leiter zwischen zwei Signalleitern (6) angebracht ist.

4. Verfahren zur Herstellung eines biegsamen Kabels gemäß Anspruch 1, mit den folgenden Schritten: Verbinden einer Kupferfolie mit einer Grundplatte (5); Herstellen eines Kupferfolienmusters (6, 11), indem die Kupferfolie einem Ätzvorgang unterzogen wird; und Überziehen des Musters (6, 11) mit einer Deckschicht (7); gekennzeichnet durch den Schritt, die Grundplatte (5) und die Deckschicht (7) so abzutrennen, daß der bzw. jeder der zusätzlichen Leiter (11) entlang der Kabellänge zur Außenseite des Kabels freiliegt.

5. Verfahren zur Herstellung eines biegsamen Kabels gemäß Anspruch 1, mit den folgenden Schritten: Verbinden einer Kupferfolie mit einer Grundplatte (5); Herstellen eines Kupferfolienmusters (6,11), indem die Kupferfolie einem Ätzvorgang unterzogen wird; sowie Verbinden einer Deckschicht (71) mit der geätzten Kupferfolie; gekennzeichnet durch Verbinden von lediglich einem vorgegebenen Teil (6) des Kupferfolienmusters (6, 11) mit der Deckschicht (71), so daß die Kupferfolie entlang der Kabellänge zur Außenseite des Kabels freiliegt.

6. Verfahren zur Herstellung eines biegsamen Kabels gemäß Anspruch 1, mit den folgenden Schritten: Anordnen einer Vielzahl von Signal- (211) und Erdungsleiterstreifen (212) in einem vorgegebenen Abstand zueinander; sandwichartiges Einschließen der Leiterstreifen (211, 212) zwischen einer Grundplatte (214) und einer Deckschicht (213); Verbinden der Deckschicht (213) mit der Grundplatte (214) zur Befestigung der Leiterstreifen (211, 212); sowie Abtrennen der Außenkante des biegsamen Kabels, um den bzw. jeden der geerdeten Leiter (212) entlang der Kabellänge zur Außenseite des Kabels freizulegen.

Fig. 1 (a)

(b)

Fig. 2 (a)

(b)

(c)

Fig. 3

EP 0 193 156 B1

# Fig. 4

(a)

(b)

(c)

(d)

(e)

Fig. 5

Fig. 6

# Fig. 6

## (a)

```
                                          201
┌─────────────────────────────────────┐
│ ALIGN CONDUCTIVE METAL SHEETS        │
│ IN A PRESCRIBED INTERVAL             │
└─────────────────────────────────────┘
                  │
                  ▼                       202
┌─────────────────────────────────────┐
│ LAMINATE BASE, CONDUCTOR AND COVER   │
│ LAYER  IN THISORDER                  │
└─────────────────────────────────────┘
                  │
                  ▼                       203
┌─────────────────────────────────────┐
│ FIX CONDUCTOR BY SUBJECTING          │
│ BASE AND COVER LAYER  TO             │
│ PRESSURE  WELDING                    │
└─────────────────────────────────────┘
                  │
                  ▼               204
          ┌───────────────────┐
          │ CUT AWAY OTHER     │
          │ SHAPE OF CABLE     │
          └───────────────────┘
```